Europäisches Patentamt

European Patent Office

Office européen des brevets

(19)

(11) Publication number: **0 335 565 B1**

# EUROPEAN PATENT SPECIFICATION

(12)

(45) Date of publication of patent specification: **15.06.94** (51) Int. Cl.<sup>5</sup>: **H05K 3/18**, H05K 3/42

(21) Application number: **89302794.6**

(22) Date of filing: **21.03.89**

(54) **Process for producing printed wiring board.**

(30) Priority: **28.03.88 JP 74119/88**
**31.03.88 JP 78383/88**
**05.04.88 JP 83384/88**
**26.07.88 JP 185755/88**

(43) Date of publication of application:
**04.10.89 Bulletin 89/40**

(45) Publication of the grant of the patent:
**15.06.94 Bulletin 94/24**

(84) Designated Contracting States:
**DE GB**

(56) References cited:
**DE-A- 2 506 150      DE-A- 2 700 868**
**DE-A- 3 505 579      GB-A- 2 047 974**
**US-A- 3 666 549      US-A- 3 959 523**

(73) Proprietor: **Hitachi Chemical Co., Ltd.**
**1-1, Nishishinjuku 2-chome**
**Shinjuku-ku, Tokyo 160(JP)**

(72) Inventor: **Takahashi, Hiroshi**
**3181-1 Inada**
**Kasama-shi(JP)**
Inventor: **Takanezawa, Shin**
**Nunogawa Hausu 2-403**
**1017, Nunogawa**
**Shimodate-shi(JP)**
Inventor: **Kanno, Masao**
**Hitachi Kasei Kogyo K K**
**Shisuiryo, 240**
**Ozakata Shimodate-shi(JP)**
Inventor: **Iwasaki, Yorio**
**699-14 Ozakata**
**Shimodate-shi(JP)**
Inventor: **Okamura, Toshirou**
**1622-81, Tamado**
**Shimodate-shi(JP)**
Inventor: **Nakaso, Akishi**
**29-29, Otome-1-chome**
**Oyama-shi(JP)**
Inventor: **Hasegawa, Kiyoshi**
**1666-1, Nishimachi**
**Yuki-shi(JP)**

(74) Representative: **Senior, Alan Murray et al**
**J.A. KEMP & CO.,**
**14 South Square**
**Gray's Inn**
**London WC1R 5LX (GB)**

**Description**

BACKGROUND OF THE INVENTION

This invention relates to a process for producing a high density printed wiring board by an additive process.

Printed wiring boards are generally produced economically by an additive process wherein necessary wiring conductors are formed by electroless plating Such a process is know from e.g DE-A-2 700 868. According to the additive process, necessary wiring patterns are formed by forming adhesive layers having thereon an electroless plating catalyst such as palladium on surfaces of an insulating substrate having the same catalyst for electroless plating, masking portions other than circuit forming portions with a plating resist, selectively roughening an adhesive surface to be formed into circuit portions with a chemical solution such as chromic acid, or the like, neutralizing and washing with water, and forming conductors on circuit portions by electroless copper plating.

With a recent demand for miniaturizing and light weighting electronic devices, printed wiring boards with high density have also been demanded, resulting in narrowing distances between through-holes and between wiring conductors. As a result, by an electric field formed between neighboring wiring conductors or conductors of inner walls of through-holes, various treating solutions retained in surface or inner portions of the insulating substrate supporting the conductors are activated to easily bring about electrolytic corrosion which accelerate migration of conductors. Thus, it is impossible to make the distance between conductors 0.15 mm or less. Further, it is also impossible to narrow the distances between through-holes, so that in order to obtain high density wiring, only the width of conductors should be reduced, resulting in producing a limit to the wiring density. As a cause for bringing about electrolytic corrosion, it is considered that migration of copper is brought about by ionic impurities contained in additive layers formed on the insulating substrate or a residue of a special treating solution used in the additive process when an electric field is applied between wiring conductors under a high temperature and high humidity.

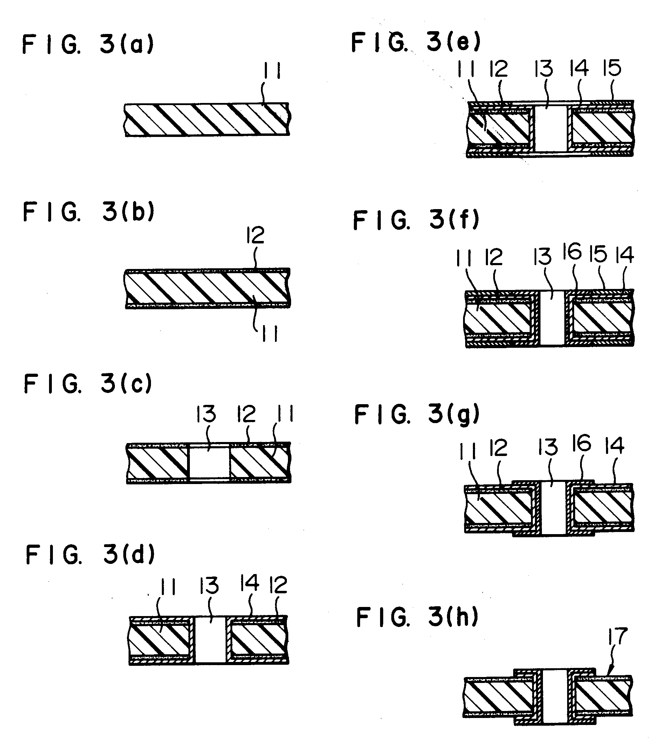

In order to solve the problem of electrolytic corrosion, it is proposed a process comprising conducting electroless nickel plating on whole surfaces of an insulating substrate having adhesive layers thereon and through holes therein, forming a plating resist on portions other than circuit portions, electroplating copper on the circuit portions, peeling the resist, and removing nickel on non-circuit portions with an ammonium persulfate solution containing benzotriazole (Japanese Patent Examined Publication No. 56-47716). This process is illustrated by Figs. 3(a) to 3(h) wherein numeral 11 denotes an insulating substrate, numeral 12 denotes an adhesive layer, numeral 13 denotes a through-hole, numeral 14 denotes a nickel plated layer, numeral 15 denotes a plating resist, numeral 16 denotes a copper plated layer, and numeral 17 denotes a printed wiring board after removing the nickel layer. But according to this process, since circuit conductors are formed by electroplating of copper on the whole surface of electroless plated nickel, there arise various problems in that the plating thickness in the through-holes obtained by electroplating of copper is not uniform, high density of wiring is difficult due to no room for changing hole diameters at the time of planing or due to no surface smoothness of conductors necessary for mounting various parts thereon, and the like.

SUMMARY OF THE INVENTION

It is an object of the present invention to provide a process for producing a printed wiring board with high density and excellent in resistance to electrolytic corrosion as well as excellent in plating processability.

The present invention provides a process for producing a printed wiring board by an additive process characterized by forming a layer of metal such as nickel which is slight in migration by an electric field by electroless plating on an insulating substrate, and forming a metallic conductor having electric conductivity such as copper thereon by electroless plating.

The present invention also provides a process for producing a printed wiring board by an additive process characterized by forming a thin layer of copper on an insulating substrate, forming a layer of metal such as nickel which is slight in migration by an electric field by electroless plating on the copper thin layer, and forming a metallic conductor having electric conductivity such as copper thereon by electroless plating.

BRIEF DESCRIPTION OF THE DRAWINGS

Figs. 1(a) to 1(f) are cross-sectional views explaining one embodiment of the process of the present invention.

Figs. 2(a) to 2(g) are cross-sectional views explaining another embodiment of the process of the present invention.

Figs. 3(a) to 3(h) are cross-sectional views explaining a process of prior art.

DESCRIPTION OF THE PREFERRED EMBODIMENTS

The process of the present invention includes

(I) a process comprising a step of forming a metallic layer of Ni, Ni alloy, Co, Co alloy, Pd or Ag on an insulating substrate, and a step of forming an electric conductive metallic layer such as copper thereon, and

(II) a process comprising a step of forming a thin layer of copper on an insulating substrate, a step of forming a layer of metal such as nickel which is slight in migration by an electric field by electroless plating on the copper thin layer, and forming a metallic conductor having electric conductivity such as copper thereon by electroless plating.

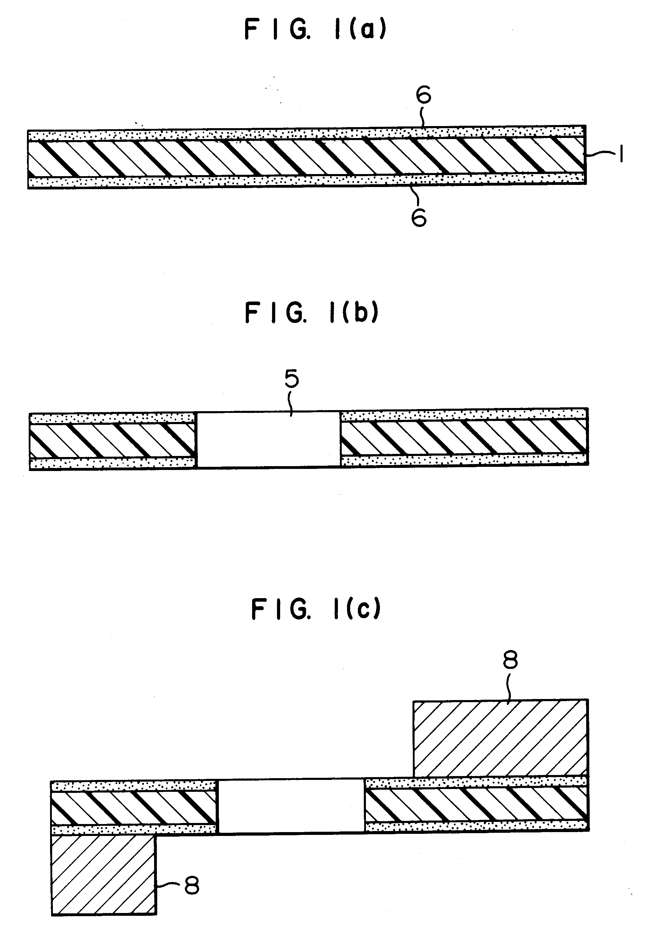

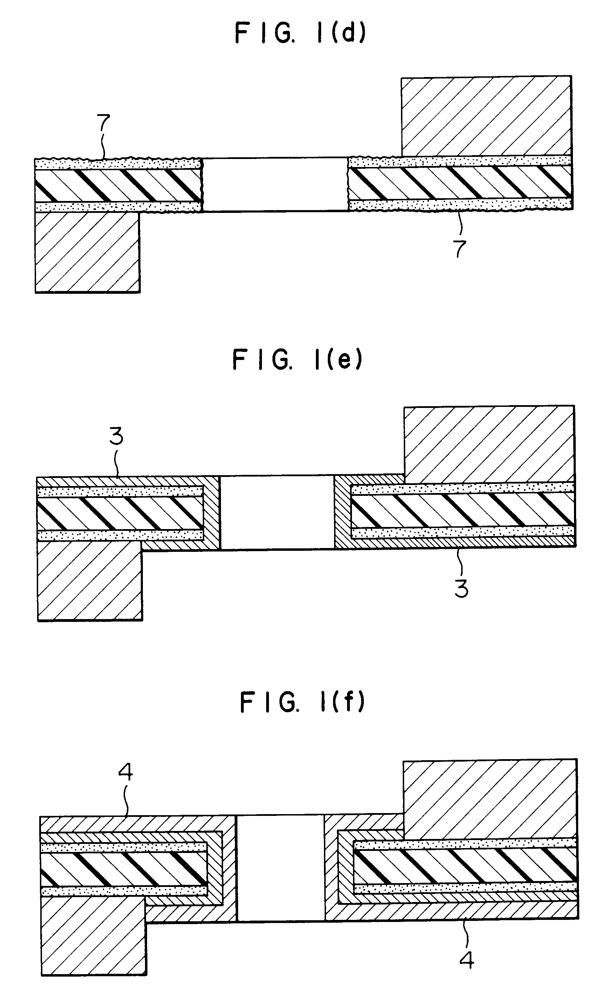

More concretely, the process (I) fundamentally comprises (with referring to Figs. 1(a) to 1(g)):

(i-a) forming an adhesive layer containing an electroless plating catalyst on surfaces of an insulating substrate containing an electroless plating catalyst (Fig. 1(a)),

(ii-b) drilling through-holes in the resulting insulating substrate (Fig. 1(b)),

(iii-c) masking portions except for the through-holes and circuit forming portions with a resist for electroless plating (Fig. 1(c)),

(iv-d) dipping the resulting substrate in a chemical roughening solution to selectively roughen the portions not masked with the resist (Fig. 1(d)),

(v-e) dipping the thus treated substrate in an electroless nickel plating solution to form nickel plated layers on the roughened portions not masked with the resist (Fig. 1(e)), and

(vi-f) dipping the nickel plated substrate in an electroless copper plating solution to conduct copper plating on the nickel plated layers (Fig. 1(f)).

In Figs. 1(a) to 1(f), numeral 1 denotes an insulating substrate, numeral 6 denotes an adhesive layer, numeral 5 denotes a through-hole, numeral 8 denotes a plating resist, numeral 7 denotes a chemically roughened surface, numeral 3 denotes a nickel plated layer, numeral 4 denotes a copper plated layer.

By the step (i-a), an adhesive layer containing an electroless plating catalyst is formed on both sides of an insulating substrate containing an electroless plating catalyst.

As the insulating substrate, there can be used conventionally used ones such as paper-epoxy resin laminates (e.g. LE-168, LE-144, etc. mfd. by Hitachi Chemical Co., Ltd.), paper-phenol resin laminates, glass fiber-epoxy resin laminates, glass cloth-epoxy resin laminates, glass cloth-polyimide laminates, etc.

As the electroless plating catalyst, there can be used palladium and its compounds, platinum and its compounds, rhodium and its compounds, etc. conventionally used in this art.

As the adhesive layer, there can be used that containing as a major component a rubber component such as acrylonitrile-butadiene rubber (NBR), butadiene rubber, styrene-butadiene rubber (SBR), etc. added with a phenolic resin, melamine resin or an epoxy resin and an inorganic filler such as silica, zirconium slicate, etc.

In the step (i-a), the insulating substrate containing an electroless plating catalyst and the adhesive layer containing an electroless plating catalyst are used.

By the step (ii-b), through-holes are drilled in the resulting substrate.

Through-holes are formed by using an apparatus such as a punch, a drill, etc., conventionally used for drilling through-holes in wiring boards.

By the step (iii-c), portions except for the through-holes and circuit forming portions are masked with a resist for electroless plating.

As the resist, there can be used an ultraviolet (UV) curing type resist film obtained by forming a light curable resin into a film followed by curing, a film obtained by, for example, screen printing a UV curable resist ink or a thermosetting resist ink, etc., followed by curing. As the material for forming the resist, there can be used conventionally used ones such as epoxy resins, acrylic resins, etc. These resists should not be peeled off during the steps of dipping in the electroless nickel plating solution, the electroless copper plating solution, and other chemical solutions used for pre-treatment or after-treatment.

By the step (iv-d), the portions not masked with the resist are selectively roughened by dipping the resulting substrate in a chemical roughening solution.

As the chemical roughening solution, there can be used those conventionally used in the additive process, for example, a mixed solution of chromic acid and sulfuric acid, a mixed solution of chromic acid and borofluoric acid, etc.

3

By the step (v-e), nickel plated layers are formed on the roughened portions not masked with the resist by dipping the thus treated substrate in an electroless nickel plating solution.

As the electroless nickel plating solution, there can be used a conventionally used one comprising a hypophosphite as a reducing agent, phosphoric acid or boron, a nickel compound such as nickel chloride, nickel nitrate, or the like. Such a nickel plating solution can be used at a temperature of preferably 40° to 95°C. Such an electroless nickel plating solution is available commercially under trade names such as Blue Shumer (mfd. by Japan Kanigen Co., Ltd.), Top Nimaron (mfd. by Okuno Seiyaku K.K.), Nimuden (mfd. by Uemura Kogyo K.K.).

The thickness of the nickel plated layer is preferably in the range of 0.5 to 10 $\mu$m from the viewpoint of prevention of electrolytic corrosion, uniformity in thickness of the plated layer and the thickness of finally produced wiring board.

By the step (vi-f), a copper plated layer is formed on the nickel plated layer by dipping the nickel plated substrate in an electroless copper plating solution.

As the electroless copper plating solution, there can be used a conventional one comprising:

| | |
|---|---|
| $CuSO_4 \cdot 5H_2O$ | 10 g/liter |
| NaCN | 15 - 30 mg/liter |
| formaline (36%) | 4 ml/liter |
| EDTA | 40 g/liter |
| pH | 12.5 (adjusted by NaOH) |

The electroless copper plating can be carried out preferably at 40° to 90°C to form a copper plated film of preferably 12 to 70 $\mu$m.

In the above-mentioned process (I), an insulating substrate containing no electroless plating catalyst can be used in the step (i-a) and roughened surfaces can be selectively exposed in place of selective roughening in the step (i-d).

Such a process (I-1) comprises steps of
(i-a') forming an adhesive layer on surfaces of an insulating substrate,
(ii-b) drilling through-holes in the resulting insulating substrate,
(iii-d') dipping the resulting substrate in a chemical roughening solution to roughen whole surfaces,
(iv-c) masking portions except for the through-holes and circuit forming portions with a resist for electroless plating,
(v-e) dipping the thus treated substrate in an electroless nickel plating solution to form nickel plated layers on the roughened portions not masked with the resist, and
(vi-f) dipping the nickel plated substrate in an electroless copper plating solution to conduct copper plating on the nickel plated layers.

In the step (i-a'), as the insulating substrate containing no electroless plating catalyst, there can be used glass cloth-epoxy resin laminates (e.g. LE-47N, LE-61N, etc. mfd. by Hitachi Chemical Co., Ltd.).

The steps (ii-b), (iv-c), (v-e), and (vi-f) are the same as mentioned above.

The process (I) can also be modified as a process (I-2) comprising:
(i-a') forming an adhesive layer on surfaces of an insulating substrate,
(ii-b) drilling through-holes in the resulting insulating substrate,
(iii-c) masking portions except for the through-holes and circuit forming portions with a resist for electroless plating,
(iv-d) dipping the resulting substrate in a chemical roughening solution to selectively roughen the portions not masked with the resist,
(v-g) dipping the resulting substrate in an aqueous solution containing palladium ions,
(vi-h) dipping the resulting substrate in a reducing agent solution,
(vii-e') dipping the thus treated substrate in an electroless plating solution to form plated layers of nickel, a nickel alloy, cobalt, a cobalt alloy, palladium, gold or a mixture thereof on the roughened portions not masked with the resist, and
(viii-f) dipping the thus plated substrate in an electroless copper plating solution to conduct copper plating on the plated layers.

In this process, the steps (ii-b), (iii-c), (iv-d), and (viii-f) are the same as mentioned above.

In the step (i-a'), as the insulating substrate, there can be used paper-phenol resin laminates, paper-epoxy resin laminates, glass cloth-epoxy resin laminates, glass cloth-polyimide resin laminates, etc. (e.g. LP-47F, LE-44, LE-67, LI-67, LI-68, mfd. by Hitachi chemical Co., Ltd.). These insulating substrates may includes electroless plating catalysts such as palladium, platinum, rhodium, etc. Further, the insulating substrate may includes inner circuits therein.

As the material for forming the adhesive layer, there can be used a resin composition containing NBR as a major component, a resin composition containing NBR and chlorosulfonated polyethylene as major components, a resin composition containing an epoxy resin as a major component, etc. These resin compositions may contain one or more fillers such as zirconium silicate, silica, calcium carbonate, aluminum hydroxide, and the like. Further, these resin compositions may contain an electroless plating catalyst such as palladium, platinum, rhodium, etc.

In the step (v-g), as the aqueous solution containing palladium ions, there can be used an aqueous solution obtained by adding hydrochloric acid to Red Shumer containing palladium ions (a trade name, mfd. by Japan Kanigen Co., Ltd.) and if necessary, further adding palladium chloride as an extender, or diluting with water to adjust properly the palladium concentration, or an aqueous solution obtained by dissolving palladium chloride in hydrochloric acid with a hydrogen chloride concentration of 2 to 20% by weight. The use of an aqueous solution of palladium in a concentration of 0.01 to 0.6% by weight is preferable for making the thickness of nickel and the like plated layer uniform.

In the step (vi-h), as the reducing agent for reducing palladium, there can be used inorganic reducing agents such as a hypophosphite, a borohydride, or organic reducing agents such as amine borane, hydrazine, etc. These compounds are generally used as a reducing agent for electroless plating solutions of copper, nickel, cobalt, gold or palladium.

After the reducing agent treatment, it is preferable to conduct washing with water or an aqueous solution of hydrochloric acid.

By employing the step (v-g) and (vi-h), the following electroless nickel plating can be carried out at a lower temperature (e.g. 60 - 70°C) compared with the case of not employing the steps (v-g) and (vi-h) wherein the temperature of 90° to 95°C is necessary.

In the step (vii-e'), a plated layer is formed by using an electroless plating solution of nickel, a nickel alloy such as Ni-W alloy, Ni-Co alloy, etc., cobalt, a cobalt alloy such as Co-W alloy, etc., palladium or gold, conventionally used in this art. More concretely, there can be used commercially available ones such as Blue Shumer (a trade name, mfd. by Japan Kanigen Co., Ltd.) which is a nickel plating solution containing a hypophosphite as a reducing agent, and phosphorus or boron, Top Nikoron (a trade name, mfd. by Okuno Seiyaku K.K.), Nimuden (a trade name, mfd. by Uemuka Kogyo K.K.), etc.

In the case of palladium or gold plated layer, the thickness of the plated layer is preferably 0.5 to 5 $\mu$m from the viewpoint of uniformity of thickness of plated layer and the thickness of finally finished wiring board. On the other hand, in the case of plated layer of other metals, the thickness of 0.5 to 10 $\mu$m is preferable by the same reasons as mentioned above.

The process (I-2) can be modified as a process (I-3) comprising

(i-a) forming an adhesive layer containing an electroless plating catalyst on surfaces of an insulating substrate containing an electroless plating catalyst,

(ii-b) drilling through-holes in the resulting substrate,

(iii-c) masking portions except for the through-holes and circuit forming portions with a resist for electroless plating,

(iv-d) dipping the resulting substrate in a chemical roughening solution to selectively roughen the portions not masked with the resist,

(v-e') dipping the thus treated substrate in an electroless plating solution to form plated layers of a nickel alloy, cobalt, a cobalt alloy, palladium, gold or a mixture thereof or a mixture thereof with nickel on the roughened portions not masked with the resist, and

(vi-f) dipping the thus plated substrate in an electroless copper plating solution to conduct copper plating on the plated layers.

The steps of (v-g) and (vi-h) of the process (I-2) can be omitting by changing the step (i-a') to the step (i-a).

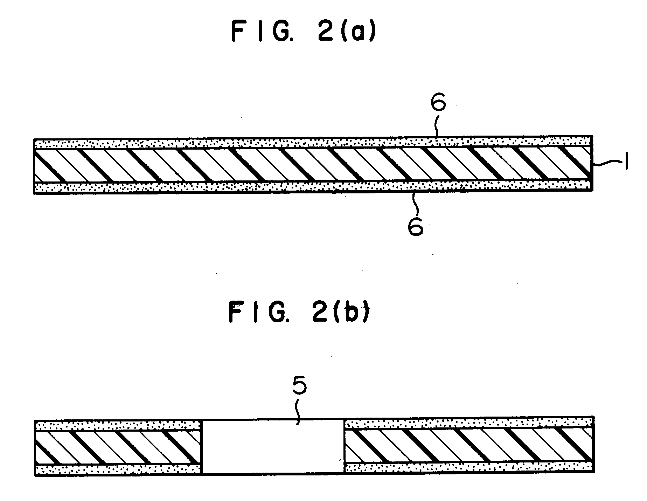

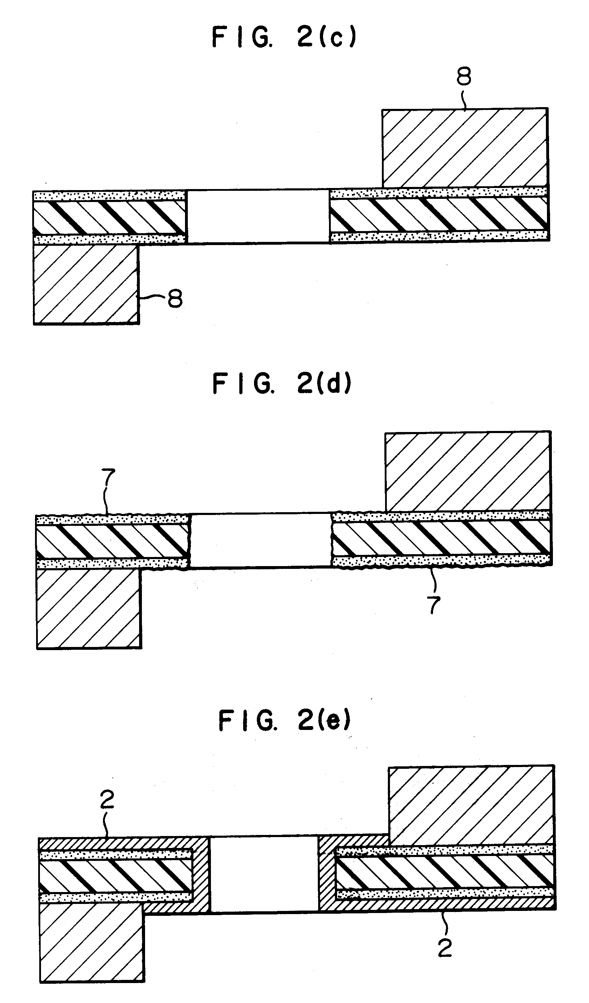

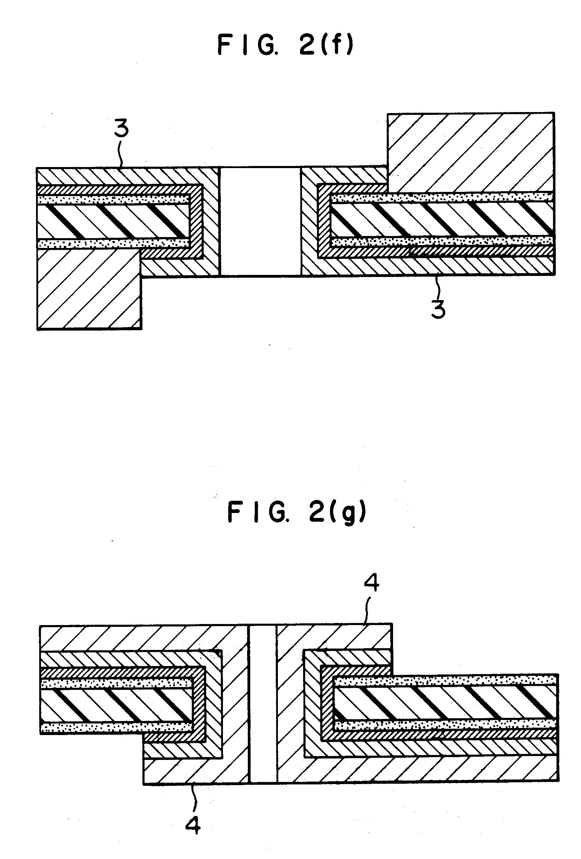

The process (I) can further be modified by inserting the step of forming a copper plated thin layer before the formation of nickel plated layer. This process (II), explained referring to Figs. 2(a) to 2(g), comprises:

(i-a) forming an adhesive layer containing an electroless plating catalyst on surfaces of an insulating substrate containing an electroless plating catalyst (Fig. 2(a)),

(ii-b) drilling through-holes in the resulting insulating substrate (Fig. 2(b)),

(iii-c) masking portions except for the through-holes and circuit forming portions with a resist for electroless plating (Fig. 2(c)),

(iv-d) dipping the resulting substrate in a chemical roughening solution to selectively roughen the portions not masked with the resist (Fig. 2(d)),

(v-f') dipping the resulting substrate in an electroless copper plating solution to form undercoating copper plated layers on the roughened portions not masked with the resist (Fig. 2(e)),

(vi-e) dipping the resulting substrate in an electroless nickel plating solution to form nickel plated layers on the undercoating copper plated layers (Fig. 2(f)), and

(vii-f) dipping the resulting substrate in an electroless copper plating solution to form copper plated layers on the nickel plated layers (Fig. 2(g)). In Figs. 2(a) to 2(g), the same reference numbers as used in Figs. 1(a) to 1(f) are used, but numeral 2 denotes a copper plated layer.

By interposing the nickel plated layer, which can inhibit the migration of components caused by application of an electric field, between the wiring conductors of copper and the insulating substrate, the problem of electrolytic corrosion can be solved. In this case, by forming the undercoating copper layer, the nickel plated layer can remarkably easily be formed without lowering resistance to electrolytic corrosion.

In the step (v-f'), as the electroless copper plating solution, there can be used those mentioned as to the step (vi-f). The thickness of undercoating copper layer is preferably 0.1 to 3 $\mu$m considering the uniformity of the successive nickel plating and resistance to electrolytic corrosion. The thickness of 1 $\mu$m or less is more preferable.

In the step (vi-e), the thickness of nickel plated layer is preferably 0.5 to 10 $\mu$m to obtain uniformity of thickness of plated layers and resistance to electrolytic corrosion. Before conducting nickel plating on the undercoating copper plated layer, it is preferable to conduct contact replacing with palladium, iron, etc., previously.

In the process (II), the steps (i-a), (ii-b), (iii-c), (iv-d) and (vii-f) are the same as mentioned above.

As mentioned previously, the electrolytic corrosion is caused by ionic impurities contained in the adhesive layers formed on both sides of the insulating substrate or a residue of special treating solutions used in the additive process, when an electric field is applied between wiring conductors under high temperatures and high humidity to migrate copper. By interposing nickel, which is a substance slight in migration of components by an electric field, between copper wiring conductors and the insulating substrate, deterioration in insulating properties on the surfaces of insulating substrate due to electrolytic corrosion at the time of application of voltage can be prevented. At this time, by adsorbing and reducing palladium selectively on circuit forming portions not masked with the resist, it becomes possible to deposit nickel or the like metal in a short time. Further, since the thickness of undercoating copper plated layer is 3 $\mu$m or less, more preferably 1 $\mu$m or less, deterioration in insulating properties by electrolytic corrosion is remarkably rare. Even if electrolytic corrosion takes place, since the thickness is thin and the migrating amount of copper is small, conductors are not short-circuited each other.

The present invnetion is illustrated by way of the following Examples, in which all percents are by weight unless otherwise specified.

Example 1

On a paper-epoxy resin laminate (LE-144, a trade name, mfd. by Hitachi Chemical Co., Ltd.) containing palladium chloride as an electroless plating catalyst, an adhesive containing NBR as a major component, and an alkyl phenol resin, an epoxy resin, and silica and zirconium silicate as fillers and palladium chloride, dissolved in a solvent was coated, dried and cured with heating to give an insulating substrate covered with the adhesive layers.

After drilling holes at predetermined positions by a punch press, a photoresist film for electroless plating made of ultraviolet curable acrylic resin (Photec SR-3000, a trade name, mfd. by Hitachi Chemical Co., Ltd.) was laminated on the resulting substrate using a vacuum laminator, followed by exposing to light and development to form the resist on portions other than circuit forming portions.

After forming the resist, the resulting substrate was dipped in a mixed solution of chromic acid and sulfuric acid (CrO$_2$ 255 g, concentrated H$_2$SO$_4$ 210 ml diluted with water to make the solution 1 liter as a whole) at 40°C for 15 minutes to selectively roughening the circuit forming portions on the adhesive layers, followed by washing with water and neutralization.

The thus roughened substrate was dipped in an electroless nickel plating solution containing a hypophosphite as a reducing agent (Blue Shumer, a trade name, mfd. by Japan Kanigen Co., Ltd.) at 90°C for 10 minutes, followed by washing with water. Then, the resulting nickel plated substrate was dipped in an electroless copper plating solution comprising:

| CuSO$_4$ • 5H$_2$O | 10 g/liter |
| NaCN | 15 mg/liter |
| formaline (36%) | 4 ml/liter |
| EDTA | 40 g/liter |
| pH | 12.5 |

at 70°C to deposit copper in 70 $\mu$m thick. Then, a solder resist was screen printed on the substrate surfaces other than the through-holes, and cured with heating to give a sample of printed wiring board.

Example 2

On a glass cloth-epoxy resin laminate containing palladium chloride, the same adhesive as used in Example 1 was coated and cured with heating to give an insulating substrate. Then, through-holes were drilled with a high speed drilling machine. A photosensitive resist film was adhered to the adhesive layers, followed by selective exposing to light and development to form a resist.

After chemically roughening the resulting substrate with the same chemical roughening solution as used in Example 1, the resulting substrate was dipped in an electroless nickel plating solution (Shumer SB-55, a trade name, mfd. by Japan Kanigen Co., Ltd.) at 90°C for 5 minutes to deposit nickel boron. Then, the resulting substrate was dipped in the same electroless copper plating solution as used in Example 1 to deposit copper in 22 $\mu$m thick. Then, a solder resist was screen printed on the substrate surfaces other than the through-holes and cured with heating in the same manner as described in Example 1 to give a sample of printed wiring board.

Example 3

On a paper-epoxy resin laminate (LE-47N, a trade name, mfd. by Hitachi Chemical Co., Ltd.), an adhesive containing NBR as a major component, an alkylphenol resin, and inorganic fillers of silica and zirconium silicate uniformly dissolved in a mixed solvent of methyl ethyl ketone and Cellosolve acetate was coated, dried and cured with heating to give an insulating substrate covered with the adhesive layers of about 30 $\mu$m thick.

After drilling holes at predetermined positions by a punch press, the resulting substrate was subjected to chemical roughening in the same manner as described in Example 1, followed by washing with water and neutralization. Then, the resulting substrate was dipped in 20% HCl for 1 minute, followed by dipping in a sensitizer HS-201B (a trade name, mfd. by Hitachi Chemical Co., Ltd.) containing palladium chloride and stannous chloride to adsorb the electroless plating catalyst. After laminating a resist film for electroless plating (Photec SR-3000, a trade name, mfd. by Hitachi Chemical Co., Ltd.) using a vacuum laminator, the resulting substrate was exposed to light and developed to mask non-circuit portions with the resist.

The resulting substrate was dipped in the same electroless nickel plating solution as used in Example 1 at 80°C for 10 minutes, followed by dipping in the same electroless copper plating solution as used in Example 1 at 70°C to deposit a copper plated layer of 20 $\mu$m thick. Then, a solder resist was screen printed on the substrate surfaces other than the through-holes, and cured with heating to give a sample of printed wiring board.

Comparative Example 1

The process of Example 1 was repeated excepted for not conducting the electroless nickel plating.

Comparative Example 2

The process of Example 2 was repeated except for not conducting the electroless nickel plating.

In the above-mentioned samples, both the conductor width and the space between conductors were made 0.1 mm, the through-hole diameter was made 0.6 mm, and the number of through-holes was made 200. Conductor patterns for evaluating electrolytic corrosion were formed on both sides of insulating substrates (via through-holes) for connecting through-holes were formed.

Electrolytic corrosion (EC) between conductors was tested by placing samples under a temperature of 65°C and relative humidity (RH) of 95%, applying a direct current of 50 V between conductors continuously, taking a part of samples after predetermined periods (100 hours and 300 hours), and measuring insulation resistance values between conductors.

Electrolytic corrosion (EC) between through-holes was tested by observing the change of cross-section of through-hole after 300 hours by the naked eye.

Solder heat resistance and peeling strength were measured according to JIS C-6481.

The results are shown in Tabel 1.

As is clear from Table 1, both the electrolytic corrosion between conductors and between through-holes are improved remarkably, while maintaining good solder heat resistance and peeling strength.

8

Table 1

|  | Examples | | | Comparative Examples | |
|---|---|---|---|---|---|
|  | 1 | 2 | 3 | 1 | 2 |
| EC between electrodes after 100 hrs | No change in resistance value | No change in resistance value | No change in resistance value | Resistance value was reduced by 50% | No change in resistance value |
| after 300 hrs | " | " | " | Short-circuited | short-circuited |
| EC between through-holes after 300 hrs | No change | No change | No change | Migration of copper | Migration of copper |
| Solder heat resistance (260°C) | $\geqq$ 60 sec. | $\geqq$ 60 sec. | $\geqq$ 60 sec. | $\geqq$ 60 sec. | $\geqq$ 60 sec. |
| Peeling strength (kgf/cm) | 2.0 | 2.1 | 1.8 | 2.0 | 2.1 |

Example 4

On a paper-epoxy resin laminate (LE-44, a trade mane, mfd. by Hitachi Chemical Co., Ltd.), a solution of adhesive containing NBS as a major component, an alkylphenol resin, an epoxy resin, and silica and

9

EP 0 335 565 B1

zirconium silicate as fillers was coated, and cured with heating to form adhesive layers. The resulting substrate was drilled by a punch press to provide through-holes at predetermined positions. A photoresist for electroless plating (Photec SR-3000, a trade name, mfd. by Hitachi Chemical Co., Ltd.) was laminated on the resulting substrate using a vacuum laminator, followed by exposure to light and development to form a plating resist on non-circuit portions.

Then, the resulting substrate was dipped in a mixed solution of $CrO_2$ (55 g/liter) and concentrated $H_2SO_4$ (210 ml) diluted with water to make a total volume 1 liter at 40°C for 15 minutes to chemically roughen circuit portions, followed by neutralization and washing with water.

The resulting substrate was dipped in an aqueous solution of 200 ml of Red Shumer (a trade name, mfd. by Japan Kanigen Co., Ltd.) and 100 ml of 35N HCl at room temperature for 15 minutes, washed with water, dipped in an aqueous solution of sodium hypophosphite (60 g/liter) at 50°C for 15 minutes, and washed with water.

The resulting substrate was dipped in an electroless nickel plating solution containing sodium hypophosphite as a reducing agent (Blue Shumer, a trade name, mfd. by Japan Kanigen Co., Ltd.) at 90°C for 20 minutes to form nickel plating layers of about 2 μm thick. Then, the substrate was dipped in the same electroless copper plating solution as used in Example 1 at 70°C to form copper plating layers of 25 μm thick on the nickel plating layers.

A solder resist was screen printed on both sides of the substrate other than the through-holes, and cured with heating to give a sample of printed wiring board.

Example 5

On a glass cloth-epoxy resin laminate (LE-67, a trade name, mfd. by Hitachi Chemical Co., Ltd.), the same adhesive as used in Example 4 was coated and cured with heating. Through-holes were drilled in the substrate using a high speed drilling machine at predetermined positions and a plating resist was formed on the substrate in the same manner as described in Example 4. Chemical roughening was conducted in the same manner as described in Example 4.

The resulting insulating substrate was dipped in an aqueous solution of palladium chloride (5 g/liter) and 35N HCl (200 ml/liter) at room temperature for 15 minutes, washed with water, dipped in an aqueous solution of sodium borohydride (3 g/liter) at 50°C for 10 minutes, and washed with water.

The resulting insulating substrate was dipped in an electroless nickel/tungsten alloy plating solution comprising:

| nickel sulfate | 7 g/liter |
| sodium tungstate | 35 g/liter |
| sodium citrate | 20 g/liter |
| sodium hypophosphite | 10 g/liter |

with pH 9.8 at 93°C for 40 minutes to form an alloy plated layer of about 2 μm thick.

Electroless copper plating and formation of solder resist were carried out in the same manner as described in Example 4 to give a sample of printed wiring board.

Example 6

On a glass cloth-epoxy resin laminate containing palladium chloride (LE-168, a trade name, mfd. by Hitachi Chemical Co., Ltd.), adhesive layers were formed in the same manner as described in Example 4.

Formation of through-holes, chemical roughening and pre-treatment for plating were carried out in the same manner as described in Example 4.

The resulting insulating substrate was dipped in an electroless nickel/cobalt alloy plating solution comprising:

| nickel sulfate | 30 g/liter |
| cobalt sulfate | 30 g/liter |
| sodium glycolate | 100 g/liter |
| sodium hypophosphite | 22 g/liter |

10

with pH 4.5 - 5.0 at 92 ° C for 40 minutes to form an alloy plated layer of about 10 $\mu$m thick.

Electroless copper plating and formation of solder resist were carried out in the same manner as described in Example 4 to give a sample of printed wiring board.

Example 7

On the same substrate as used in Example 5, adhesive layers were formed in the same manner as described in Example 5.

The resulting substrate was dipped in an aqueous solution containing palladium chloride (5 g/liter), 35N HCl (200 ml/liter) and dimethylformamide (DMF) (5 ml/liter) for 10 minutes, washed with water, dipped in an aqueous solution of dimethylamino borane (5 g/liter) at 50 ° C for 10 minutes), and washed with water.

Then, the resulting substrate was dipped in an electroless cobalt plating solution comprising:

| cobalt chloride | 35 g/liter |
| sodium citrate | 116 g/liter |
| sodium hypophosphite | 10 g/liter |

with pH 9.0 at 90 ° C for 60 minutes to form a plated layer of about 6 $\mu$m thick.

Electroless copper plating and formation of solder resist were carried out in the same manner as described in Example 4 to give a sample of printed wiring board.

Example 8

On the same insulating substrate as used in Example 7, the formation of adhesive layers, formation of plating resist layers, chemical roughening and plating pre-treatment were carried out in the same manner as described in Example 5.

The resulting substrate was dipped in an electroless palladium plating solution comprising:

| tetramine palladium chloride | 7.5 g/liter |
| EDTA-2Na | 8.0 g/liter |
| ammonia water | 280 g/liter |
| hydrazine (1 mole/liter) | 8 ml/liter |

at 38 ° C for 60 minutes to form a plated layer of about 1 $\mu$m thick.

Electroless copper plating and formation of solder resist were carried out in the same manner as described in Example 4 to give a sample of printed wiring board.

Example 9

Using the same insulating substrate as used in Example 4, the formation of adhesive layers and plating resist layers, chemical roughening and plating pre-treatment were carried out in the same manner as described in Example 4.

The resulting substrate was dipped in an electroless gold plating solution comprising

| potassium cyanoaurate | 2 g/liter |
| ammonium chloride | 75 g/liter |
| sodium citrate | 50 g/liter |
| sodium hypophosphite | 10 g/liter |

with pH 7.0 - 7.5 at 92 ° C for 30 minutes to form a plated layer of about 0.5 $\mu$m thick,

Electroless copper plating and formation of solder resist were carried out in the same manner as described in Example 4 to give a sample of printed wiring board.

11

Example 10

On a paper-epoxy resin laminate containing palladium chloride as an electroless plating catalyst (LE-144, a trade name, mfd. by Hitachi Chemical Co., Ltd.), the same adhesive as used in Example 4 was coated, and cured with heating to provide an insulating substrate covered with adhesive layers.

Drilling of through-holes, formation of a plating resist and chemical roughening were conducted in the same manner as described in Example 4.

The resulting substrate was dipped in an aqueous solution containing 0.2 g of palladium chloride, 100 ml of 35N HCl and 1000 ml of water at room temperarure for 5 minutes to adsorb the palladium chloride selectively on the roughened surfaces. After washing with water, the substrate was dipped in a 10% aqueous solution of sodium hypophosphite (a reducing solution) at 60°C for 3 minutes for activation.

Then, the resulting substrate was dipped in an electroless nickel plating solution (Blue Shumer, a trade name, mfd. by Japan Kanigen Co., Ltd.) at 60°C for 10 minutes to form nickel plated layers of about 4 $\mu$m thick.

Electroless copper plating and formation of solder resist were carried out in the same manner as described in Example 4 to give a sample of printed wiring board.

Example 11

On the same glass cloth-epoxy resin laminate as used in Example 5, the same adhesive as used in Example 4 was coated and cured with heating to give an insulating substrate covered with adhesive layers.

Then, through-holes were drilled in the substrate using a high speed drilling machine. A photosensitive resist films were adhered to both sides of the substrate, selectively exposed to light and developed to form plating resists.

After chemically roughening in the same manner as described in Example 4, the substrate was dipped in an aqueous solution containing 200 ml of Red Shumer containing palladium ions (a trade name, mfd. by Japan Kanigen Co., Ltd.), 100 ml of 35N HCl, and 800 ml of water (Pd concentration: about 0.01%) at room temperature for 3 minutes, washed with water, and dipped in an aqueous ammonium solution of 0.5% by dimethyl aminoborane (a reducing solution) at 50°C for 3 minutes for activation. After repeating this step twice, an electroless nickel plating was carried out by dipping the substrate in an electroless nickel plating solution (Shumer SB-55, a trade name, mfd. by Japan Kanigen Co., Ltd.) at 60°C for 5 minutes to form a nickel plated layer of about 3 $\mu$m thick.

Electroless copper plating and formation of solder resist were carried out in the same manner as described in Example 4 to give a sample of printed wiring board.

Comparative Example 3

The process of Example 4 was repeated except for not conducting electroless nickel plating to give a sample of printed wiring board.

Comparative Example 4

The process of Example 5 was repeated except for not conducting electroless nickel/tungsten alloy plating to give a sample of printed wiring board.

Comparative example 5

The process of Example 10 was repeated except for not conducting electroless nickel plating to give a sample of printed wiring board.

Comparative Example 6

The process of Example 11 was repeated except for not conducting electroless nickel plating to give a sample of printed wiring board.

Comparative Example 7

The process of Example 10 was repeated except that the electroless nickel plating was conducted without dipping in the aqueous solution containing palladium ions. In this case, no uniform plated layer was formed on the circuit portions even if the nickel plating was conducted at the solution temperature of 60°C for 60 minutes.

Comparative Example 8

The process of Example 11 was repeated except that the electroless nickel plating was conducted without dipping in the aqueous solution containing palladium ions. In this case, no plated layer was formed on the circuit portions even if the nickel plating was conducted at the solution temperature of 60°C for 60 minutes.

In the above-mentioned samples of Examples 4 to 11 and Comparative Examples 3 to 8, both the conductor width and the space between conductors were made 0.1 mm, the through-hole diameter was made 0.6 mm, and the number of through-holes was made 200. Conductor patterns were made in the same manner as described in Examples 1 to 3.

Electrolytic corrosion (EC) between conductors, and between through-holes (generation of dendrite), solder heat resistance and peeling strength were measured in the same manner as described in Examples 1 to 3.

The results are shown in Table 2.

As is clear from Table 2, both the electrolytic corrosion between conductors and between through-holes are improved remarkably, while maintaining good solder heat resistance and peeling strength. Further the nickel plating can be carried out at not so high temperatures.

13

Table 2

| | Examples | | | | | | |
|---|---|---|---|---|---|---|---|
| | 4 | 5 | 6 | 7 | 8 | 9 | 10 |
| EC between electrodes after 100 hrs | No change | No change | No change | No change | No change | No change | No change |
| after 300 hrs | " | " | " | " | " | " | " |
| EC between through-holes after 300 hrs | No change | No change | No change | No change | No change | No change | No change |
| Solder heat resistance (260°C) | $\geq$ 60 sec | $\geq$ 60 sec | $\geq$ 60 sec | $\geq$ 60 sec | $\geq$ 60 sec | $\geq$ 60 sec | $\geq$ 60 sec |
| Peeling strength (kgf/cm) | 2.1 | 2.1 | 2.1 | 2.1 | 1.8 | 1.9 | 2.1 |

(to be cont'd)

EP 0 335 565 B1

Table 2 (Cont'd)

| | Comparative Examples | | | | | | |
|---|---|---|---|---|---|---|---|
| | 11 | 3 | 4 | 5 | 6 | 7 | 8 |
| | No change | Resistance value was reduced by 50% | No change | Resistance value was reduced by 50% | No change | — | — |
| | " | Short-circuited | Short-circuited | Short-circuited | Short-circuited | | — |
| | No change | Migration of copper | Migration of copper | Migration of copper | Migration of copper | — | — |
| | $\geq$ 60 sec | $\geq$ 60 sec | $\geq$ 60 sec | $\geq$ 60 sec | $\geq$ 60 sec | — | — |
| | 2.1 | 2.0 | 2.1 | 1.8 | 1.9 | — | — |

Example 12

On a glass cloth-epoxy resin laminate containing palladium chloride as an electroless plating catalyst (LE-144, a trade name, mfd. by Hitachi Chemical Co., Ltd.), a solution of adhesive containing NBR as a major component, an alkylphenol resin, an epoxy resin, silica, zirconium silicate as inorganic fillers, and palladium chloride was coated and cured with heating to form adhesive layers.

After drilling through-holes at predetermined positions using a punch press, the resulting substrate was laminated with a photoresist film for electroless plating (Photec SR-3000) using a vacuum laminator, exposed to light on non-circuit portions, and developed to remove non-exposed portions to form a resist. The circuit width and the space between conductors were 0.15 mm, respectively.

The resist formed substrate was dipped in a solution containing 55 g of $CrO_2$ and 210 ml of concentrated $H_2SO_4$ and diluted with water to make a total volume 1 liter at 55°C for 10 minutes to chemically roughen circuit forming portions selectively, followed by washing with water and neutralization.

The resulting substrate was dipped in an electroless nickel/tungsten alloy plating solution comprising:

| | |
|---|---|
| nickel sulfate | 7 g/liter |
| sodium tungstate | 35 g/liter |
| sodium citrate | 20 g/liter |
| sodium hypophosphite | 10 g/liter |

with pH 9.8 at 93°C for 60 minutes to form alloy plated layers of about 2 $\mu$m thick.

After washing with water, the substrate was dipped in the same electroless copper plating solution as used in Example 1 at 70°C to form copper plated layers of about 20 $\mu$m thick. A solder resist was screen printed on both surfaces of the substrate except for the through-holes and cured with heating to give a sample of printed wiring board.

Example 13

On a glass cloth-epoxy resin laminate containing palladium chloride (LE-168, a trade name, mfd. by Hitachi Chemical Co., Ltd.), the same adhesive as used in Example 12 was coated and cured with heating to form adhesive layers.

After drilling through-holes at predetermined positions using a high speed drilling machine, the substrate was laminated with a photoresist film for electroless plating (Photec SR-3000) using a vacuum laminator, exposed to light and developed to form resists on non-circuit portions.

The resist formed substrate was dipped in a solution containing 55 g of $CrO_2$ and 210 ml of concentrated $H_2SO_4$ and diluted with water so as to make a total volume 1 liter at 55°C for 10 minutes to chemically roughen circuit forming portions selectively, followed by washing with water and neutralization.

Then, the resulting substrate was dipped in an electroless cobalt/nickel alloy plating solution comprising

| | |
|---|---|
| cobalt chloride | 30 g/liter |
| nickel chloride | 30 g/liter |
| sodium glycolate | 100 g/liter |
| sodium hypophosphite | 22 g/liter |

with pH 4.5 - 5.0 at 92°C for 50 minutes to form alloy plated layers of about 10 $\mu$m thick.

After washing with water, the substrate was dipped in the same electroless copper plating solution as used in Example 1 at 70°C to form copper plated layers of about 20 $\mu$m thick on the alloy plated layers. A solder resist was screen printed on both surfaces of the resulting substrate except for the through-holes and cured with heating to give a sample of printed wiring board.

Example 14

On a glass cloth-epoxy resin laminate containing palladium chloride (LE-168), the same adhesive as used in Example 12 was coated and cured with heating to form adhesive layers.

After drilling through-holes at predetermined positions using a high speed drilling machine, the substrate was laminated with a photoresist film for electroless plating (Photec SR-3000) using a vacuum laminator, exposed to light and developed to form resists on non-circuit portions.

The resist formed substrate was dipped in a solution containing 55 g of $CrO_2$ and 210 ml of concentrated $H_2SO_4$ and diluted with water so as to make a total volume 1 liter at 55°C for 10 minutes to chemically roughen circuit forming portions selectively, followed by washing with water and neutralization.

Then, the resulting substrate was dipped in an electroless cobalt plating solution comprising

EP 0 335 565 B1

| cobalt chloride | 35 g/liter |
| sodium citrate | 116 g/liter |
| sodium hypophosphite | 11.5 g/liter |

with pH 8.0 - 10.0 at 90°C for 60 minutes to form cobalt plated layers of about 5 $\mu$m thick.

After washing with water, the substrate was dipped in the same electroless copper plating solution as used in Example 1 at 70°C to form copper plated layers of about 20 $\mu$m thick on the cobalt plated layers. A solder resist was screen printed on both surfaces of the resulting substrate except for the through-holes and cured with heating to give a sample of printed wiring board.

Example 15

On a glass cloth-epoxy resin laminate containing palladium chloride (LE-168), the same adhesive as used in Example 12 was coated and cured with heating to form adhesive layers.

After drilling through-holes at predetermined positions using a high speed drilling machine, the substrate was laminated with a photoresist film for electroless plating (Photec SR-3000) using a vacuum laminator, exposed to light and developed to form resists on non-circuit portions.

The resist formed substrate was dipped in a solution containing 55 g of $CrO_2$ and 210 ml of concentrated $H_2SO_4$ and diluted with water so as to make a total volume 1 liter at 55°C for 10 minutes to chemically roughen circuit forming portions selectively, followed by washing with water and neutralization.

Then, the resulting substrate was dipped in an electroless palladium plating solution comprising

| tetramine palladium chloride | 7.5 g/liter |
| EDTA-2Na | 8.0 g/liter |
| ammonia water | 280 g/liter |
| hydrazine (1 mole/liter) | 8 ml/liter |

at 38°C for 60 minutes to form palladium plated layers of about 1 $\mu$m thick.

After washing with water, the substrate was dipped in the same electroless copper plating solution as used in Example 1 at 70°C to form copper plated layers of about 20 $\mu$m thick on the palladium plated layers. A solder resist was screen printed on both surfaces of the resulting substrate except for the through-holes and cured with heating to give a sample of printed wiring board.

Example 16

On a glass cloth-epoxy resin laminate containing palladium chloride (LE-168), the same adhesive as used in Example 12 was coated and cured with heating to form adhesive layers.

After drilling through-holes at predetermined positions using a high speed drilling machine, the substrate was laminated with a photoresist film for electroless plating (Photec SR-3000) using a vacuum laminator, exposed to light and developed to form resists on non-circuit portions.

The resist formed substrate was dipped in a solution containing 55 g of $CrO_2$ and 210 ml of concentrated $H_2SO_4$ and diluted with water so as to make a total volume 1 liter at 55°C for 10 minutes to chemically roughen circuit forming portions selectively, followed by washing with water and neutralization.

Then, the resulting substrate was dipped in an electroless gold plating solution comprising

| potassium cyanoaurate | 2 g/liter |
| ammonium chloride | 75 g/liter |
| sodium citrate | 50 g/liter |
| sodium hypophosphite | 10 g/liter |

with pH 7.0 - 7.5 at 92°C for 30 minutes to form plated layers of about 0.5 $\mu$m thick.

After washing with water, the substrate was dipped in the same electroless copper plating solution as used in Example 1 at 70°C to form copper plated layers of about 20 $\mu$m thick on the plated layers. A solder resist was screen printed on both surfaces of the resulting substrate except for the through-holes and cured with heating to give a sample of printed wiring board.

17

Comparative Example 9

The process of Example 12 was repeated except for not conducting the electroless nickel/tungsten alloy plating to give a sample of printed wiring board.

Comparative Example 10

The process of Example 13 was repeated except for not conducting the electroless cobalt/nickel alloy plating to give a sample of printed wiring board.

In the above-mentioned samples of Examples 12 to 16 and Comparative Examples 9 and 10, both the conductor width and the space between conductors were made 0.1 mm, the through-hole diameter was made 0.6 mm, and the number of through-holes was made 200. Conductor patterns were made in the same manner as described in Examples 1 to 3.

Electrolytic corrosion (EC) between conductors, and between through-holes (generation of dendrite), solder heat resistance and peeling strength were measured in the same manner as described in Examples 1 to 3.

The results are shown in Table 3.

Table 3

| | Examples | | | | | Comparative Examples | |
|---|---|---|---|---|---|---|---|
| | 12 | 13 | 14 | 15 | 16 | 9 | 10 |
| EC between electrodes after 100 hrs | No change | No change | No change | No change | No change | Resistance value was reduced by 50% | No change |
| after 300 hrs | " | " | " | " | " | Short-circuited | Short-circuited |
| EC between through-holes after 300 hrs | No change | No change | No change | No change | No change | Migration of copper | Migration of copper |
| Solder heat resistance (260°C) | ≧ 60 sec | ≧ 60 sec | ≧ 60 sec | ≧ 60 sec | ≧ 60 sec | ≧ 60 sec | ≧ 60 sec |
| Peeling strength (kgf/cm) | 2.1 | 2.1 | 2.1 | 1.8 | 1.9 | 2.0 | 2.1 |

As if clear from Table 3, both the electrolytic corrosion between conductors and between through-holes are improved remarkably, while maintaining good solder heat resistance and peeling strength.

Example 17

On a paper-epoxy resin laminate containing palladium chloride (LE-144), the same adhesive as used in Example 12 was coated and cured with heating to form adhesive layers.

After drilling through-holes at predetermined positions using a punch press, the substrate was laminated with a photoresist film for electroless plating (Photec SR-3000) using a vacuum laminator, exposed to light and developed to form resists on non-circuit portions.

The resist formed substrate was dipped in a solution containing 55 g of $CrO_2$ and 210 ml of concentrated $H_2SO_4$ and diluted with water so as to make a total volume 1 liter at 40°C for 15 minutes to chemically roughen circuit forming portions selectively, followed by washing with water and neutralization.

The resulting substrate was dipped in the same electroless copper plating solution as used in Example 1 at 70°C to form copper plated layers of 0.3 $\mu$m thick. Then, the substrate was dipped in an electroless nickel plating solution containing a hypophosphite as a reducing agent (Blue Shumer, a trade name, mfd. by Japan Kanigen Co., Ltd.) at 70°C. After contacting with a SUS brush in this plating solution, the substrate was continued to be dipped for 10 minutes to form nickel plated layers of about 5 $\mu$m thick. After washing with water, the substrate was dipped in the same electroless copper plating solution as used in Example 1 at 70°C to form copper plated layers of 20 $\mu$m thick. A solder resist was screen printed on both surfaces of the substrate except for the through-holes and cured with heating to give a sample of printed wiring board.

Example 18

On a glass cloth-epoxy resin laminate containing palladium chloride, the same adhesive as used in Example 12 was coated and cured with heating to form adhesive layers.

After drilling through-holes at predetermined positions using a high speed drilling machine, the formation of plating resists was conducted in the same manner as described in Example 17.

After chemically roughening in the same manner as described in Example 17, the substrate was subjected to formation of copper plated layers of 1 $\mu$m thick in the same manner as described in Example 17. Then, the substrate was dipped in an aqueous HCl solution containing 0.01% of palladium chloride for 3 minutes, washed with water, dipped in a 10% HCl solution for 5 minutes, and washed with water. The resulting substrate was dipped in an electroless nickel plating solution (Shumer SB-55, a trade name, mfd. by Japan Kanigen Co., Ltd.) at 60°C for 5 minutes to form boron nickel plated layers of 1 $\mu$m thick.

Then, the substrate was dipped in the same electroless copper plating solution as used in Example 17 at 70°C to form copper plated layers of 22 $\mu$m thick. A solder resist was screen printed on both surfaces of the substrate except for the through-holes and cured with heating to give a sample of printed wiring board.

Comparative Example 11

The process of Example 17 was repeated except for omitting the step of conducting electroless nickel plating and conducting only the copper plating to give a sample of printed wiring board.

In the above-mentioned samples of Examples 17 and 18, and Comparative Example 11, both the conductor width and the sapce between conductors were made 0.1 mm, the through-hole diameter was made 0.6 mm, and the number of through-holes was made 200. Conductor patterns were made in the same manner as described in Examples 1 to 3.

Electrolytic corrosion (EC) between conductors and between through-holes (generation of dendrite) were measured in the same manner as described in Examples 1 to 3. The generation of dendrite was observed using a microscope with magnification of 100.

The results are shown in Table 4.

EP 0 335 565 B1

Table 4

|  | | Examples | | Comparative Example 11 |
|---|---|---|---|---|
|  | | 17 | 18 | |
| Electrolytic corrosion between conductors | After 100 hrs | No change | No change | Resistance value was reduced by 50%. Short-circuited |
| | After 300 hrs | No change | Resistance value was reduced by 10%. | |
| Electrolytic corrosion between through-holes (generation of dendrite) | After 100 hrs | No change | Slightly generated at cathode side | Much generated from cathode side |
| | After 300 hrs | slightly generated at cathode side | Generated branchedly from cathode side | Bridge was generated between conductors |

As is clear from Table 4, the printed wiring boards obtained by the process of the present invention are excellent in not deteriorating insulating properties and suitable for forming high density wiring.

**Claims**

1. A process for producing a printed wiring board, which comprises
    (i-a) forming an adhesive layer (6) containing an electroless plating catalyst on surfaces of an insulating substrate (1) containing an electroless plating catalyst,
    (ii-b) drilling through-holes (5) in the resulting insulating substrate (1),
    (iii-c) masking portions except for the through-holes (5) and circuit forming portions with a resist (8) for electroless plating,
    (iv-d) dipping the resulting substrate in a chemical roughening solution to selectively roughen the portions not masked with the resist (8),
    (v-e) dipping the thus treated substrate in an electroless nickel plating solution to form nickel plated layers (3) on the roughened portions (7) not masked with the resist (8), and
    (vi-f) dipping the nickel plated substrate in an electroless copper plating solution to conduct copper plating on the nickel plated layers (3).

2. A process for producing a printed wiring board, which comprises
    (1-a′) forming an adhesive layer (6) on surfaces of an insulating substrate (1),
    (ii-b) drilling through-holes (5) in the resulting insulating substrate (1),
    (iii-d′) dipping the resulting substrate in a chemical roughening solution to roughen whole surfaces,
    (iv-c) masking portions except for the through-holes (5) and circuit forming portions with a resist (8) for electroless plating,
    (v-e) dipping the thus treated substrate in an electroless nickel plating solution to form nickel plated layers (3) on the roughened portions (7) not masked with the resist (8), and
    (vi-f) dipping the nickel plated substrate in an electroless copper plating solution to conduct copper plating on the nickel plated layers (3).

3. A process according to Claim 1, wherein the nickel plated layer (3) has a thickness of 0.5 to 10 $\mu$m.

4. A process according to Claim 2, wherein the nickel plated layer (3) has a thickness of 0.5 to 10 $\mu$m.

5. A process for producing a printed wiring board, which comprises
    (i-a′) forming an adhesive layer (6) on surfaces of an insulating substrate (1),
    (ii-b) drilling through-holes (5) in the resulting insulating substrate (2),
    (iii-c) masking portions except for the through-holes (5) and circuit forming portions with a resist (8) for electroless plating,
    (iv-d) dipping the resulting substrate in a chemical roughening solution to selectively roughen the portions not masked with the resist (8),

(v-g) dipping the resulting substrate in an aqueous solution containing palladium ions,

(vi-h) dipping the resulting substrate in a reducing agent solution,

(vii-e′) dipping the thus treated substrate in an electroless plating solution to form plated layers of nickel, a nickel alloy, cobalt, a cobalt alloy, palladium, gold or a mixture thereof on the roughened portions not masked with the resist (8), and

(viii-f) dipping the thus plated substrate in an electroless copper plating solution to conduct copper plating on the plated layers.

6. A process according to Claim 5, wherein the aqueous solution contains palladium ions in a concentration of 0.01 to 0.6% by weight.

7. A process for producing a printed wiring board, which comprises

(i-a) forming an adhesive layer (6) containing an electroless plating catalyst on surfaces of an insulating substrate (1) containing an electroless plating catalyst,

(ii-b) drilling through-holes (5) in the resulting substrate,

(iii-c) masking portions except for the through-holes (5) and circuit forming portions with a resist (8) for electroless plating,

(iv-d) dipping the resulting substrate in a chemical roughening solution to selectively roughen the portions not masked with the resist (8),

(v-e′) dipping the thus treated substrate in an electroless plating solution to form plated layers of a nickel alloy, cobalt, a cobalt alloy, palladium, gold or a mixture thereof or a mixture thereof with nickel on the roughened portions (7) not masked with the resist (8), and

(vi-f) dipping the thus plated substrate in an electroless copper plating solution to conduct copper plating on the plated layers.

8. A process for producing a printed wiring board, which comprises

(i-a) forming an adhesive layer (6) containing an electroless plating catalyst on surfaces of an insulating substrate (1) containing an electroless plating catalyst,

(ii-b) drilling through-holes (5) in the resulting insulating substrate (1),

(iii-c) masking portions except for the through-holes (5) and circuit forming portions with a resist (8) for electroless plating,

(iv-d) dipping the resulting substrate in a chemical roughening solution to selectively roughen the portions not masked with the resist (8),

(v-f′) dipping the resulting substrate in an electroless copper plating solution to form undercoating copper plated layers on the roughened portions (7) not masked with the resist (8),

(vi-e) dipping the resulting substrate in an electroless nickel plating solution to form nickel plated layers (3) on the undercoating copper layers, and

(vii-f) dipping the resulting substrate in an electroless copper plating solution to form copper plated layers (4) on the nickel plated layers (3).

9. A process according to Claim 8, wherein the undercoating copper plated (4) layer has a thickness of 0.1 to 3 $\mu$m and the nickel plated layer (3) has a thickness of 0.5 to 10 $\mu$m.

**Patentansprüche**

1. Verfahren zur Herstellung einer gedruckten Leiterplatte bzw. Schaltungsplatte, dadurch **gekennzeichnet ,** daß man

(i-a) eine einen Katalysator für die stromlose Plattierung enthaltende Klebschicht (6) auf den Oberflächen eines isolierenden Substrats (1), das einen Katalysator für die stromlose Plattierung enthält, bildet,

(ii-b) in das resultierende isolierende Substrat (1) Durchgangslöcher (5) einbohrt,

(iii-c) Teile, ausgenommen die Durchgangslöcher (5) und die eine Schaltung bzw. einen Stromkreis bildenden Teile, mit einem Resist (8) für das stromlose Plattieren maskiert,

(iv-d) das resultierende Substrat in eine chemische Aufrauhlösung eintaucht, um die mit dem Resist (8) nicht maskierten Teile selektiv aufzurauhen,

(v-e) das so behandelte Substrat in eine Lösung für die stromlose Nickelplattierung eintaucht, um auf den aufgerauhten Teilen (7), die nicht mit dem Resist (8) maskiert sind, Nickelplattierungsschichten (3) zu bilden, und daß man

22

(vi-f) das Nickel-plattierte Substrat in eine Lösung für die stromlose Kupferplattierung eintaucht, um auf den Nickelplattierungsschichten (3) eine Kupferplattierung durchzuführen.

2. Verfahren zur Herstellung einer gedruckten Leiterplatte bzw. Schaltungsplatte, dadurch **gekennzeichnet ,** daß man

(1-a') auf den Oberflächen eines isolierenden Substrats (1) eine Klebschicht (6) bildet,

(ii-b) in das resultierende isolierende Substrat (1) Durchgangslöcher (5) einbohrt,

(iii-d') das resultierende Substrat in eine chemische Aufrauhlösung eintaucht, um die gesamten Oberflächen aufzurauhen,

(iv-c) Teile, ausgenommen die Durchgangslöcher (5) und die eine Schaltung bzw. einen Stromkreis bildenden Teile, mit einem Resist (8) für das stromlose Plattieren maskiert,

(v-e) das so behandelte Substrat in eine Lösung für die stromlose Nickelplattierung eintaucht, um auf den aufgerauhten Teilen (7), die nicht mit dem Resist (8) maskiert sind, Nickelplattierungsschichten (3) zu bilden, und daß man

(vi-f) das Nickel-plattierte Substrat in eine Lösung für die stromlose Kupferplattierung eintaucht, um auf den Nickelplattierungsschichten (3) eine Kupferplattierung durchzuführen.

3. Verfahren nach Anspruch 1, dadurch **gekennzeichnet ,** daß die Nickelplattierungsschicht (3) eine Dicke von 0,5 bis 10 $\mu$m hat.

4. Verfahren nach Anspruch 2, dadurch **gekennzeichnet ,** daß die Nickelplattierungsschicht (3) eine Dicke von 0,5 bis 10 $\mu$m hat.

5. Verfahren zur Herstellung einer gedruckten Leiterplatte bzw. Schaltungsplatte, dadurch **gekennzeichnet ,** daß man

(1-a') auf den Oberflächen eines isolierenden Substrats (1) eine Klebschicht (6) bildet,

(ii-b) in das resultierende isolierende Substrat (1) Durchgangslöcher (5) einbohrt,

(iii-c) Teile, ausgenommen die Durchgangslöcher (5) und die eine Schaltung bzw. einen Stromkreis bildenden Teile, mit einem Resist (8) für das stromlose Plattieren maskiert,

(iv-d) das resultierende Substrat in eine chemische Aufrauhlösung eintaucht, um die mit dem Resist (8) nicht maskierten Teile selektiv aufzurauhen,

(v-g) das resultierende Substrat in eine Palladiumionen-enthaltende wäßrige Lösung eintaucht,

(vi-h) das resultierende Substrat in die Lösung eines Reduktionsmittels eintaucht,

(vii-e') das so behandelte Substrat in eine Lösung für die stromlose Plattierung eintaucht, um Plattierungsschichten von Nickel, einer Nickellegierung, Kobalt, einer Kobaltlegierung, Palladium, Gold oder eines Gemisches davon auf den nicht mit dem Resist (8) maskierten aufgerauhten Teilen zu bilden, und daß man

(viii-f) das so plattierte Substrat in eine Lösung für die stromlose Kupferplattierung eintaucht, um eine Kupferplattierung auf den Plattierungsschichten durchzuführen.

6. Verfahren nach Anspruch 5, dadurch **gekennzeichnet ,** daß die wäßrige Lösung Palladiumionen in einer Konzentration von 0,01 bis 0,6 Gew.-% enthält.

7. Verfahren zur Herstellung einer gedruckten Leiterplatte bzw. Schaltungsplatte, dadurch **gekennzeichnet ,** daß man

(i-a) eine einen Katalysator für die stromlose Plattierung enthaltende Klebschicht (6) auf den Oberflächen eines isolierenden Substrats (1), das einen Katalysator für die stromlose Plattierung enthält, bildet,

(ii-b) in das resultierende Substrat (1) Durchgangslöcher (5) einbohrt,

(iii-c) Teile, ausgenommen die Durchgangslöcher (5) und die eine Schaltung bzw. einen Stromkreis bildenden Teile, mit einem Resist (8) für das stromlose Plattieren maskiert,

(iv-d) das resultierende Substrat in eine chemische Aufrauhlösung eintaucht, um die mit dem Resist (8) nicht maskierten Teile selektiv aufzurauhen,

(v-e') das so behandelte Substrat in eine Lösung für die stromlose Plattierung eintaucht, um Plattierungsschichten einer Nickellegierung, von Kobalt, einer Kobaltlegierung, Palladium, Gold oder eines Gemisches davon oder eines Gemisches davon mit Nickel auf den nicht mit dem Resist (8) maskierten aufgerauhten Teilen (7) zu bilden, und daß man

(vi-f) das so plattierte Substrat in eine Lösung für die stromlose Kupferplattierung eintaucht, um eine Kupferplattierung auf den Plattierungsschichten durchzuführen.

8. Verfahren zur Herstellung einer gedruckten Leiterplatte bzw. Schaltungsplatte, dadurch **gekennzeichnet** , daß man

(i-a) eine einen Katalysator für die stromlose Plattierung enthaltende Klebschicht (6) auf den Oberflächen eines isolierenden Substrats (1), das einen Katalysator für die stromlose Plattierung enthält, bildet,

(ii-b) in das resultierende isolierende Substrat (1) Durchgangslöcher (5) einbohrt,

(iii-c) Teile, ausgenommen die Durchgangslöcher (5) und die eine Schaltung bzw. einen Stromkreis bildenden Teile, mit einem Resist (8) für das stromlose Plattieren maskiert,

(iv-d) das resultierende Substrat in eine chemische Aufrauhlösung eintaucht, um die mit dem Resist (8) nicht maskierten Teile selektiv aufzurauhen,

(v-f') das resultierende Substrat in eine Lösung für die stromlose Kupferplattierung eintaucht, um Unterschicht-Kupferplattierungsschichten auf den nicht mit dem Resist (8) maskierten aufgerauhten Teilen (7) zu bilden,

(vi-e) das resultierende Substrat in eine Lösung für die stromlose Nickelplattierung eintaucht, um Nickelplattierungsschichten (3) auf den Unterschicht-Kupferschichten zu bilden, und daß man

(vii-f) das resultierende Substrat in eine Lösung für die stromlose Kupferplattierung eintaucht, um Kupferplattierungsschichten (4) auf den Nickelplattierungsschichten (3) zu bilden.

9. Verfahren nach Anspruch 8, dadurch **gekennzeichnet** , daß die Unterschicht-Kupferplattierungsschicht (4) eine Dicke von 0,1 bis 3 $\mu$m hat und daß die Nickelplattierungsschicht (3) eine Dicke von 0,5 bis 10 $\mu$m hat.

**Revendications**

1. Procédé de production d'une carte de circuits imprimés, qui comprend :
(i-a) la formation d'une couche d'adhésif (6), contenant un catalyseur pour le dépôt sans courant, sur les faces d'un support isolant (1) contenant un catalyseur pour le dépôt sans courant,
(ii-b) le perçage de trous de passage (5) dans le support isolant résultant (1),
(iii-c) le masquage des parties, à l'exception des trous de passage (5) et des parties formant le circuit, avec une réserve (8) pour dépôt sans courant,
(iv-d) l'immersion du support résultant dans une solution chimique créant des rugosités, pour rendre rugueuses, sélectivement, les parties non masquées par la réserve (8),
(v-e) l'immersion du support ainsi traité dans une solution pour le dépôt de nickel sans courant, pour former des couches déposées de nickel (3) sur les parties rendues rugueuses (7), non masquées par la réserve (8), et
(vi-f) l'immersion du support revêtu de nickel dans une solution pour le dépôt de cuivre sans courant, pour effectuer le dépôt de cuivre sur les couches déposées de nickel (3).

2. Procédé de production d'une carte de circuits imprimés, qui comprend :
(i-a') la formation d'une couche d'adhésif (6) sur les faces d'un support isolant (1),
(ii-b) le perçage de trous de passage (5) dans le support isolant résultant (1),
(iii-d') l'immersion du support résultant dans une solution chimique créant des rugosités, de façon à rendre rugueuse la totalité des faces,
(iv-c) le masquage des parties, à l'exception des trous de passage (5) et des parties formant le circuit, avec une réserve (8) pour dépôt sans courant,
(v-e) l'immersion du support ainsi traité dans une solution pour le dépôt de nickel sans courant, pour former des couches déposées de nickel (3) sur les parties rendues rugueuses (7), non masquées par la réserve (8), et
(vi-f) l'immersion du support revêtu de nickel dans une solution pour le dépôt de cuivre sans courant, pour effectuer le dépôt de cuivre sur les couches déposées de nickel (3).

3. Procédé selon la revendication 1, dans lequel la couche déposée de nickel (3) a une épaisseur de 0,5 à 10 $\mu$m.

24

4. Procédé selon la revendication 2, dans lequel la couche déposée de nickel (3) a une épaisseur de 0,5 à 10 $\mu$m.

5. Procédé de production d'une carte de circuits imprimés, qui comprend :

(i-a') la formation d'une couche d'adhésif (6) sur les faces d'un support isolant (1),

(ii-b) le perçage de trous de passage (5) dans le support isolant résultant (1),

(iii-c) le masquage des parties, à l'exception des trous de passage (5) et des parties formant le circuit, avec une réserve (8) pour dépôt sans courant,

(iv-d) l'immersion du support résultant dans une solution chimique créant des rugosités, pour rendre rugueuses, sélectivement, les parties non masquées par la réserve (8),

(v-g) l'immersion du support résultant dans une solution aqueuse contenant des ions palladium,

(vi-h) l'immersion du support résultant dans une solution d'agent réducteur,

(vii-e') l'immersion du support ainsi traité dans une solution pour dépôt sans courant, pour former des couches déposées de nickel, d'alliage de nickel, de cobalt, d'alliage de cobalt, de palladium, d'or ou d'un mélange des composés précédents, sur les parties rendues rugueuses, non masquées par la réserve (8), et

(viii-f) l'immersion du support ainsi revêtu dans une solution pour le dépôt de cuivre sans courant, pour effectuer le dépôt de cuivre sur les couches déposées.

6. Procédé selon la revendication 5, dans lequel la solution aqueuse contient des ions palladium à une concentration de 0,01 à 0,6% en poids.

7. Procédé de production d'une carte de circuits imprimés, qui comprend :

(i-a) la formation d'une couche d'adhésif (6), contenant un catalyseur pour le dépôt sans courant, sur les faces d'un support isolant (1), contenant un catalyseur pour le dépôt sans courant,

(ii-b) le perçage de trous de passage (5) dans le support résultant,

(iii-c) le masquage des parties, à l'exception des trous de passage (5) et des parties formant le circuit, avec une réserve (8) pour dépôt sans courant,

(iv-d) l'immersion du support résultant dans une solution chimique créant des rugosités, pour rendre rugueuses, sélectivement, les parties non masquées par la réserve (8),

(v-e') l'immersion du support ainsi traité dans une solution pour le dépôt sans courant, pour former des couches déposées d'un alliage de nickel, de cobalt, d'un alliage de cobalt, de palladium, d'or ou d'un mélange des composés précédents, ou d'un mélange des composés précédents avec du nickel, sur les parties rendues rugueuses (7), non masquées par la réserve (8), et

(vi-f) l'immersion du support ainsi revêtu dans une solution pour le dépôt de cuivre sans courant, pour effectuer le dépôt de cuivre sur les couches déposées.

8. Procédé de production d'une carte de circuits imprimés, qui comprend :

(i-a) la formation d'une couche d'adhésif (6), contenant un catalyseur pour le dépôt sans courant, sur les faces d'un support isolant (1), contenant un catalyseur pour le dépôt sans courant,

(ii-b) le perçage de trous de passage (5) dans le support isolant résultant (1),

(iii-c) le masquage des parties, à l'exception des trous de passage (5) et des parties formant le circuit, avec une réserve (8) pour dépôt sans courant,

(iv-d) l'immersion du support résultant dans une solution chimique créant des rugosités, pour rendre rugueuses, sélectivement, les parties non masquées par la réserve (8),

(v-f') l'immersion du support résultant dans une solution pour le dépôt de cuivre sans courant, pour former des couches déposées de cuivre, constituant une sous-couche, sur les parties rendues rugueuses (7), non masquées par la réserve (8),

(vi-e) l'immersion du support résultant dans une solution pour le dépôt du nickel sans courant, pour former des couches déposées de nickel (3) sur les couches de cuivre, constituant la sous-couche, et

(vii-f) l'immersion du support résultant dans une solution pour le dépôt de cuivre sans courant, pour former des couches déposées de cuivre (4) sur les couches déposées de nickel (3).

9. Procédé selon la revendication 8, dans lequel la couche déposée de cuivre, constituant la sous-couche, a une épaisseur de 0,1 à 3 $\mu$m, et la couche déposée de nickel (3) a une épaisseur de 0,5 à 10 $\mu$m.

FIG. 1(a)

FIG. 1(b)

FIG. 1(c)

# F I G. I(d)

7

7

# F I G. I(e)

3

3

# F I G. I(f)

4

4

FIG. 2(a)

FIG. 2(b)

FIG. 2(c)

FIG. 2(d)

FIG. 2(e)

F I G. 2(f)

F I G. 2(g)

FIG. 3(a)

FIG. 3(e)

FIG. 3(b)

FIG. 3(f)

FIG. 3(c)

FIG. 3(g)

FIG. 3(d)

FIG. 3(h)